# EUROPÄISCHE PATENTSCHRIFT

(11) **EP 4 212 292 B1**
(45) Veröffentlichungstag und Bekanntmachung des Hinweises auf die Patenterteilung: **10.07.2024**
(21) Anmeldenummer: 23151053.8
(22) Anmeldetag: 11.01.2023
(51) Int. Cl.: B25J 15/06, B25J 9/16, B25J 19/02, B65G 47/91

(54) **SAUGGREIFEREINRICHTUNG MIT VERSCHLEISSDETEKTIONSEINRICHTUNG**
SUCTION GRIPPER DEVICE WITH WEAR DETECTION DEVICE
DISPOSITIF DE PRÉHENSION PAR ASPIRATION DOTÉ D'UN DISPOSITIF DE DÉTECTION D'USURE

(30) Priorität: 17.01.2022 DE 102022100986
(43) Veröffentlichungstag der Anmeldung: 19.07.2023
(73) Patentinhaber: J. Schmalz GmbH, 72293 Glatten (DE)
(72) Erfinder: Schaaf, Walter, 72250 Freudenstadt-Grüntal (DE)
(74) Vertreter: DREISS Patentanwälte PartG mbB

(56) Entgegenhaltungen:
- EP-A2- 3 998 142
- WO-A1-2021/079738
- US-A1- 2020 361 098
- US-B2- 8 855 818

## Beschreibung

Die Erfindung betrifft eine Sauggreifereinrichtung mit einem Saugkörper und mit einer Verschleißdetektionseinrichtung zur Detektion eines Verschleißzustandes des Saugkörpers.

Sauggreifereinrichtungen dienen insbesondere zum Greifen von Gegenständen mittels Unterdruck und finden beispielsweise als Endeffektoren in Unterdruckhandhabungsanlagen Verwendung. Sie umfassen üblicherweise wenigstens einen Saugkörper, der einen Sauginnenraum begrenzt und einen Anlageabschnitt bzw. Dichtlippe zur Anlage an einen zu greifenden Gegenstand aufweist. Um einen Gegenstand zu greifen, wird der Saugkörper mit dem Anlageabschnitt an den zu greifenden Gegenstand angesetzt und dann der Sauginnenraum des Saugkörpers mit Unterdruck beaufschlagt. Zum Ablegen des Gegenstands wird der Sauginnenraum dann wieder belüftet.

Es sind Sauggreifer mit unterschiedlich ausgebildeten Saugkörpern bekannt. Beispielsweise sind Elastomersauger bekannt, bei denen der Saugkörper aus einem Elastomermaterial besteht, welches sich beim Ansaugen an eine Außenfläche des zu greifenden Gegenstands dichtend anschmiegt. Außerdem sind Sauggreifer bekannt, bei denen der Saugkörper aus einem porösen Schaummaterial besteht, durch welches ein zu greifender Gegenstand angesaugt werden kann.

Bei bestimmungsgemäßem Gebrauch eines solchen Saugkörpers, also insbesondere bei wiederholtem Ansaugen und Ablegen eines Gegenstands, kommt es in der Regel zu gebrauchsbedingtem Verschleiß des Saugkörpers, insbesondere durch mechanischen Abrieb im Bereich des Anlageabschnittes. Ein solcher gebrauchsbedingter Verschleiß kann insbesondere dazu führen, dass eine Dichtwirkung des Saugkörpers beeinträchtigt wird und somit ein Gegenstand nicht mehr mit der gewünschten Zuverlässigkeit gegriffen werden kann. Daher ist es wichtig, einen Verschleißzustand des Saugkörpers überwachen zu können.

Zu diesem Zweck ist es beispielsweise aus EP 1 816 094 B1 bekannt, den Saugkörper zumindest abschnittsweise mit einem Element auszustatten, dessen Farbe sich im Laufe der Zeit ändert und auf diese Weise einen Verschleißzustand des Saugkörpers repräsentiert. Aus EP 1 826 160 B1 ist ferner bekannt, einen Verschleißzustand des Saugkörpers durch elektrische Messungen zu überwachen. Aus WO 2021/079738 A1 ist zudem eine Vorrichtung zur Ermittlung eines Verschleißzustands eines Saugkörpers bekannt, welcher anhand der zeitlichen Änderung der Verformung der Adsorptionseinheit bei der Adsorption des Objekts ermittelt wird. EP 3 998 142 A2 offenbart ein Greifsystem zum Ansaugen und Handhaben von Objekten und ein Anbaumodul zum Nachrüsten eines bestehenden Greifsystems durch Anordnen an ein bestehendes Greifsystem, wobei am oder im Grundmodul wenigstens ein Sensor und am oder im Saugnapf wenigstens ein Sensorelement vorgesehen sind. Das wenigstens eine Sensorelement umfasst einen Magneten, ein ferromagnetisches Metall und/oder ein durch den wenigstens einen Sensor detektierbares Material.

US 8 855 818 B2 offenbart eine Überwachungsvorrichtung zur Überwachung des Zustands eines Endeffektors eines Roboters durch Prüfung des erzeugten Unterdrucks. US 2020/361098 A1 offenbart eine Vakuumgreifvorrichtung, welche einen Saugnapf umfasst, welcher einen Befestigungskörper aufweist und von dem aus sich eine elastisch verformbare Schürze erstreckt, die einen freien ringförmigen Rand aufweist, der dazu bestimmt ist, mit einem zu greifenden Gegenstand in Kontakt zu kommen. Der Saugnapf umfasst eine elektrisch leitende Schiene, die mit der Schürze fest verbunden ist. So verformen sich die Schürze und die Leiterbahn gemeinsam und die elektrische Eigenschaft ändert sich mit der Verformung. Die Überwachung der elektrischen Eigenschaft ermöglicht es daher, die Anzahl der Zyklen zu zählen. Mit Hilfe von Tests kann auch die normale Veränderung der elektrischen Eigenschaft bestimmt werden, so dass jede anormale Veränderung dieser elektrischen Eigenschaft eine Anomalie aufzeigt, wie z. B. Alterung oder Abnutzung des Materials, aus dem die Leiterbahn besteht.

Der Erfindung liegt die Aufgabe zugrunde, bei einer Sauggreifereinrichtung einen Verschleißzustand des Saugkörpers mit einfachen Mitteln zuverlässig bestimmen zu können.

Diese Aufgabe wird durch eine Sauggreifereinrichtung mit den Merkmalen des Anspruchs 1 gelöst.

Die Sauggreifereinrichtung umfasst wenigstens einen Saugkörper zum Ansaugen eines Gegenstands. Insbesondere kann es sich bei dem Saugkörper um einen Elastomersauger oder um ein poröses Schaummaterial handeln. Der Saugkörper kann insbesondere Teil eines übergeordneten Sauggreifers sein, beispielsweise eines Flächensauggreifers. Der Saugkörper unterliegt im Zuge seines bestimmungsgemäßen Gebrauchs, also insbesondere bei wiederholtem Ansaugen und Ablegen eines Gegenstands, zumindest abschnittsweise einem gebrauchsbedingten Verschleiß. Insbesondere unterliegt der Saugkörper einem mechanischen Abrieb. Der gebrauchsbedingte Verschleiß tritt insbesondere in einem Anlageabschnitt des Saugkörpers auf, mittels dessen der Saugkörper an einen anzusaugenden Gegenstand angelegt wird.

Die Sauggreifereinrichtung umfasst außerdem eine Verschleißdetektionseinrichtung zur Detektion eines Verschleißzustandes, insbesondere eines Verschleißgrades, des Saugkörpers. Insbesondere ist die Verschleißdetektionseinrichtung dazu ausgebildet, zu detektieren, ob und gegebenenfalls wie viel Material des Saugkörpers durch Verschleiß, bspw. durch Reibkontakt mit einem angesaugten Gegenstand, bereits abgerieben wurde.

Die Verschleißdetektionseinrichtung umfasst eine Magnetfeldeinrichtung zum Bereitstellen eines Prüfmagnetfeldes. Die Magnetfeldeinrichtung ist derart ausgebildet, dass sich das bereitgestellte Prüfmagnetfeld in Abhängigkeit eines fortschreitenden gebrauchsbedingten Verschleißes des Saugkörpers verändert. Insbesondere kann sich eine magnetische Feldstärke und/oder eine Richtung des Prüfmagnetfeldes verändern. Es ist denkbar, dass sich das Prüfmagnetfeld bei gebrauchsbedingtem Verschleiß des Saugkörpers stets mit verändert. Es ist auch denkbar, dass sich das Prüfmagnetfeld erst bei Erreichen eines vorgegebenen Verschleißgrades, insbesondere bei Erreichen einer vorgegebenen Abriebmenge, des Saugkörpers verändert.

Die Verschleißdetektionseinrichtung umfasst außerdem eine Sensoreinrichtung zur Detektion des Prüfmagnetfeldes, insbesondere zur Detektion einer magnetischen Feldstärke und/oder einer Richtung des Prüfmagnetfeldes. Vorzugsweise umfasst die Sensoreinrichtung wenigstens einen Magnetfeldsensor, beispielsweise einen Hall-Sensor.

Die Sauggreifereinrichtung kann außerdem eine Steuereinrichtung zur Ansteuerung der Verschleißdetektionseinrichtung umfassen, insbesondere zur Ansteuerung der Magnetfeldeinrichtung und/oder der Sensoreinrichtung.

Eine solche Sauggreifereinrichtung ermöglicht es, einen Verschleißzustand des Saugkörpers zuverlässig und automatisiert zu überwachen. Die Verschleißdetektion basiert auf dem Grundprinzip, dass das Prüfmagnetfeld sich im Zuge eines gebrauchsbedingten Verschleißes des Saugkörpers verändert und somit durch Detektion einer Veränderung des Prüfmagnetfeldes mittels der Sensoreinrichtung ein Verschleißzustand des Saugkörpers bestimmt werden kann. Dadurch, dass die Detektion auf der Erfassung von magnetischen Feldern beruht, ist eine kontaktlose Überwachung des Sauggreifers möglich. Insbesondere ist keine elektrische Kontaktierung des Saugkörpers erforderlich, was eine Herstellung erleichtert und die Verschleißdetektion robust gegenüber elektrischen Störfeldern im Sauggreiferumfeld macht.

Die Magnetfeldeinrichtung kann insbesondere ein Magnetmaterial umfassen oder daraus bestehen. Bei dem Magnetmaterial handelt es sich insbesondere um magnetisch leitfähiges Material. Es ist denkbar, dass das Magnetmaterial dazu ausgebildet ist, das Prüfmagnetfeld selbst bereitzustellen, insbesondere selbst abzugeben. Dann kann es sich bei dem Magnetmaterial insbesondere um permanent-magnetisches Material handeln, also um ein Material, welches, vorzugsweise dauerhaft, ein Magnetfeld bereitstellt.

Es ist auch denkbar, dass das Magnetmaterial dazu ausgebildet ist, das Prüfmagnetfeld dadurch zu erzeugen, dass es ein Anregungsmagnetfeld zu dem Prüfmagnetfeld verändert. Das Anregungsmagnetfeld kann insbesondere von einer, insbesondere von dem Magnetmaterial separaten, magnetfeldabgebenden Einrichtung bereitgestellt sein. Dann kann es sich bei dem Magnetmaterial insbesondere um permanent-magnetisches Material oder zumindest magnetisch polarisierbares Material handeln. Vorzugsweise handelt es sich bei dem Magnetmaterial dann um ferromagnetisches Material.

Die Sauggreifereinrichtung kann eine magnetfeldabgebende Einrichtung zur Bereitstellung des Anregungsmagnetfeldes umfassen. Die magnetfeldabgebende Einrichtung kann aber grundsätzlich auch extern bereitgestellt sein. Im Rahmen einer besonders einfachen und robusten Ausgestaltung kann die magnetfeldabgebende Einrichtung ein oder mehrere Permanentmagneten umfassen oder daraus bestehen. Der wenigstens eine Permanentmagnet kann insbesondere in den Saugkörper integriert sein, beispielsweise in einer Saugkörperwandung eingebettet sein.

Das Magnetmaterial kann insbesondere derart ausgebildet und angeordnet sein, dass es bei bestimmungsgemäßem Gebrauch der Sauggreifereinrichtung, insbesondere im Zuge eines gebrauchsbedingten Verschleißes des Saugkörpers, selbst verschleißt, insbesondere einem Materialabrieb unterliegt. Infolge des Verschleißes des Magnetmaterials werden dessen magnetische Eigenschaften und somit das von dem Magnetmaterial bereitgestellte Magnetfeld oder dessen Einwirkung auf ein Anregungsmagnetfeld verändert. Beispielsweise wird durch Abrieb des Magnetmaterials ein Volumen an Magnetmaterial reduziert, was Stärke und Richtung des Prüfmagnetfeldes beeinflussen kann. Aus der resultierenden Veränderung des Prüfmagnetfeldes lässt sich dann auf einen Verschleißzustand des Saugkörpers schließen.

Es ist denkbar, dass das Magnetmaterial derart ausgebildet und angeordnet ist, dass es bei einem gebrauchsbedingten Verschleiß des Saugkörpers automatisch mit verschleißt, insbesondere mit einem Verschleiß des Saugkörpers korrelierend. Auf diese Weise ist eine kontinuierliche, insbesondere stufenlose Überwachung des Verschleißzustandes des Saugkörpers möglich.

Es ist auch denkbar, dass das Magnetmaterial derart ausgebildet und angeordnet ist, dass es erst bei Erreichen eines vorgegebenen Verschleißgrades, insbesondere erst bei Erreichen einer vorgegebenen Abriebmenge des Saugkörpers, verschleißt (bspw. erst nach mehreren durchgeführten Greifzyklen). Insofern kann das Magnetmaterial derart ausgebildet und angeordnet sein, dass es erst dann beginnt zu verschleißen, wenn der Saugkörper bereits zu einem gewissen Grad abgenutzt ist. Bei einer solchen Ausgestaltung ist ein Abrieb des Magnetmaterials im Zuge eines bestimmungsgemäßen Gebrauchs der Sauggreifereinrichtung reduziert. Bei dem vorgegebenen Verschleißgrad kann es sich insbesondere um einen Grenz-Verschleißgrad des Saugkörpers handeln, bei dem der Saugkörper unmittelbar oder in naher Zukunft (bspw. spätestens nach weiteren 100 Greifzyklen) ausgetauscht werden muss.

Bei dem Magnetmaterial kann es sich insbesondere um ein Verbundmaterial aus einem ersten Material und magnetischen, insbesondere permanent-magnetischen und/oder magnetisch polarisierbaren, vorzugsweise ferromagnetischen, Füllkörpern handeln. Insbesondere können die Füllkörper in dem ersten Material eingebettet sein. Bei einem solchen Verbundmaterial können für einen Abrieb vorteilhafte Eigenschaften (z.B. Einstellen eines ähnlichen Abriebwiderstands wie Saugkörpermaterial; kein metallischer Abrieb) mit guten magnetischen Eigenschaften kombiniert werden. Beispielsweise kann das erste Material ein Elastomermaterial oder ein Schaummaterial umfassen, insbesondere das gleiche Material, aus dem auch der Saugkörper hergestellt ist. Es ist möglich, dass die Füllkörper in dem ersten Material fein verteilt sind, sodass makroskopisch betrachtet ein homogenes Material vorliegt. Es ist auch möglich, dass das Verbundmaterial nur vergleichsweise wenige, dann größere Füllkörper aufweist.

Im Rahmen einer vorteilhaften Ausgestaltung kann der Saugkörper zumindest abschnittsweise aus dem Magnetmaterial hergestellt sein, insbesondere in einem Anlageabschnitt (Dichtlippe) zur Anlage an einen zu greifenden Gegenstand. Dies ermöglicht eine direkte und somit besonders genaue Messung eines Verschleißzustands des Saugkörpers. Zudem ist eine solche Sauggreifereinrichtung kompakt aufgebaut, da die Anzahl an Einzelbauteilen reduziert ist. Es ist grundsätzlich auch denkbar, dass das Magnetmaterial auf einer einem Sauginnenraum des Saugkörpers zugewandten Innenseite oder einer dem Sauginnenraum des Saugkörpers abgewandten Außenseite des Saugkörpers angeordnet ist, beispielsweise in Form einer Beschichtung.

Das Magnetmaterial kann auch in Form wenigstens eines Prüfkörpers bereitgestellt sein. Der wenigstens eine Prüfkörper kann grundsätzlich beliebige Formen aufweisen, beispielsweise quaderförmig, plattenförmig, stabförmig, oder kugelförmig.

Im Rahmen einer vorteilhaften Ausgestaltung kann der wenigstens eine Prüfkörper in den Saugkörper integriert sein, insbesondere in einer Saugkörperwandung des Saugkörpers. Beispielsweise ist es denkbar, dass der wenigstens eine Prüfkörper in einem den Saugkörper bereitstellenden Saugkörpermaterial eingebettet ist.

Alternativ oder ergänzend ist es auch denkbar, dass wenigstens ein Prüfkörper von dem Saugkörper separat bereitgestellt ist. Beispielsweise ist es denkbar, dass der wenigstens eine Prüfkörper mittels eine Halteeinrichtung an dem Saugkörper bzw. einer übergeordneten Greiferstruktur befestigt ist.

Unabhängig davon, ob der wenigstens eine Prüfkörper in den Saugkörper integriert ist oder von dem Saugkörper separat bereitgestellt ist, kann der wenigstens eine Prüfkörper derart angeordnet sein, dass er bei Verschleiß des Saugkörpers automatisch mit verschleißt. Dies ermöglicht eine kontinuierliche, insbesondere stufenlose Überwachung des Verschleißzustands des Saugkörpers. Beispielsweise kann der wenigstens eine Prüfkörper derart angeordnet sein, dass im Neuzustand der Sauggreifereinrichtung eine Verschleißfläche des Prüfkörpers bündig mit einem Anlageabschnitt bzw. Dichtlippe des Sauggreifers angeordnet ist, insbesondere derart, dass beim Aufsetzen des Saugkörpers auf einen zu greifenden Gegenstand sowohl der Saugkörper als auch der Prüfkörper in Kontakt mit dem Gegenstand stehen.

Es kann auch vorteilhaft sein, wenn der wenigstens eine Prüfkörper in einer vorgegebenen Tiefenposition in einer Verschleißrichtung angeordnet ist. Insofern kann der wenigstens eine Prüfkörper insbesondere derart angeordnet sein, dass er im Neuzustand der Sauggreifereinrichtung, also in einem unverschlissenen Zustand des Saugkörpers, zu einem Anlageabschnitt des Saugkörpers beabstandet ist. Mit anderen Worten kann der wenigstens eine Prüfkörper derart angeordnet sein, dass der wenigstens eine Prüfkörper erst bei Erreichen eines vorgegebenen Verschleißgrades des Saugkörpers, insbesondere einer vorgegebenen Abriebmenge, verschleißt. Bei einer solchen Ausgestaltung wird also zunächst keine oder nur eine geringfügige Änderung des Prüfmagnetfeldes detektiert und erst dann, wenn der Saugkörper bereits zu einem gewissen Grad abgenutzt ist, eine signifikante Änderung des Prüfmagnetfeldes detektiert. Vorzugsweise kann die Tiefenposition einem Grenz-Verschleißgrad des Saugkörpers entsprechen, bei Erreichen dessen der Saugkörper unmittelbar oder in naher Zukunft ausgetauscht werden muss. Bei einer solchen Ausgestaltung ist der bei bestimmungsgemäßem Gebrauch erzeugte Abrieb reduziert, da das Magnetmaterial nicht kontinuierlich mit verschleißt, sondern erst dann, wenn der Saugkörper ausgetauscht werden muss.

Es ist auch möglich, dass eine Mehrzahl von Prüfkörpern vorgesehen ist, welche in unterschiedlichen Tiefenpositionen in Verschleißrichtung angeordnet sind. Dies erlaubt eine engmaschigere Überwachung des Verschleißzustands, ohne kontinuierlichen Abrieb des Magnetmaterials zu erzeugen.

Im Rahmen einer vorteilhaften Ausgestaltung kann die Verschleißdetektionseinrichtung als von dem Saugkörper separat bereitgestelltes Detektionsmodul ausgebildet sein. Die Sauggreifereinrichtung kann insofern ein Detektionsmodul umfassen, welches insbesondere die Magnetfeldeinrichtung und die Sensoreinrichtung umfasst. Insbesondere kann das Detektionsmodul eine Modulschnittstelle aufweisen, über die das Detektionsmodul mit dem Saugkörper bzw. einer mit dem Saugkörper verbundenen Greiferstruktur verbindbar ist.

Die Verschleißdetektionseinrichtung kann außerdem eine mit der Sensoreinrichtung zusammenwirkende Auswerteeinrichtung aufweisen, insbesondere umfassend eine Datenverarbeitungsanlage. Die Auswerteeinrichtung kann insbesondere dazu eingerichtet sein, in Abhängigkeit des von der Sensoreinrichtung detektierten Prüfmagnetfeldes ein Verschleißsignal zu erzeugen, das den Verschleißzustand des Saugkörpers repräsentiert. Insofern kann auf einfache Weise automatisiert ein Verschleißzustand des Saugkörpers ermittelt werden. Die Auswerteeinrichtung kann separat bereitgestellt sein, also nicht mit dem Sauggreifer verbunden sein. Beispielsweise ist es denkbar, dass die Auswerteeinrichtung Teil eines Cloud-Computersystems ist. Dann kann die Sensoreinrichtung über eine Kommunikationsschnittstelle, zum Beispiel eine WLAN- oder LAN-Schnittstelle, verfügen, über welche Messsignale an die Auswerteeinrichtung übermittelt werden können. Es ist aber auch möglich, dass die Auswerteeinrichtung an dem Sauggreifer selbst angeordnet ist. Die Auswerteeinrichtung kann beispielsweise eine Anzeigeeinrichtung umfassen, welche einen Verschleißzustand des Saugkörpers visualisiert.

In vorteilhafter Weise kann die Auswerteeinrichtung dazu eingerichtet sein, zum Erzeugen des Verschleißsignals ein von der Sensoreinrichtung empfangenes Messsignal mit einem in einer Speichereinrichtung der Auswerteeinrichtung hinterlegten Referenzmesssignal zu vergleichen. Insbesondere kann das Verschleißsignal dann einen betriebsgeeigneten Verschleißzustand des Saugkörpers repräsentieren, wenn das Messsignal einen vorgegebenen, insbesondere in der Speichereinrichtung der Auswerteeinrichtung hinterlegten oder hinterlegbaren, Schwellwert überschreitet. Das Verschleißsignal kann insbesondere dann einen betriebsungeeigneten Verschleißzustand des Sauggreifers repräsentieren, wenn das Messsignal den Schwellwert unterschreitet.

Die Erfindung wird im Folgenden anhand der Figuren näher erläutert.

Es zeigen:
- Fig. 1: schematische Darstellung einer ersten Ausgestaltung einer Sauggreifereinrichtung in einer teilweisen Schnittansicht; und
- Fig. 2: schematische Darstellung einer zweiten Ausgestaltung einer Sauggreifereinrichtung in einer teilweisen Schnittansicht.

In der nachfolgenden Beschreibung sowie in den Figuren sind für identische oder einander entsprechende Merkmale jeweils dieselben Bezugszeichen verwendet.

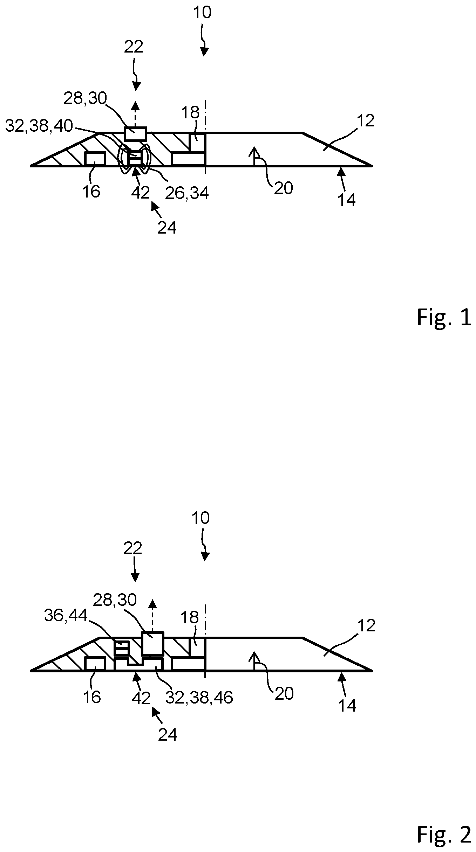

Die Figur 1 zeigt eine erste Ausgestaltung einer Sauggreifereinrichtung, welche insgesamt mit dem Bezugszeichen 10 bezeichnet ist. Die Sauggreifereinrichtung 10 umfasst einen Saugkörper 12, welcher in dem dargestellten Beispiel als Elastomersauger ausgebildet ist.

Bei nicht dargestellten Ausgestaltungen kann es sich bei dem Saugkörper 12 beispielsweise auch um ein poröses Schaummaterial handeln.

Der Saugkörper 12 dient zum Ansaugen und somit zum Greifen eines Gegenstands (nicht dargestellt). Bei bestimmungsgemäßem Gebrauch wird der Sauggreifer 12 hierzu mit einem Anlageabschnitt 14 an eine Außenfläche des zu greifenden Gegenstands aufgesetzt und der Gegenstand dann mittels Unterdruck angesaugt. Zu diesem Zweck umfasst der Saugkörper 12 mehrere Unterdruckkanäle 16, welche über einen Unterdruckanschluss 18 mit Unterdruck versorgbar sind. Beispielsweise kann der Unterdruckanschluss 18 mit einer Unterdruckerzeugungsvorrichtung (nicht dargestellt) verbunden sein. Zum Ablegen eines angesaugten Gegenstands können dann die Unterdruckkanäle 16 wieder belüftet werden, beispielsweise über den Anschluss 18.

Im Zuge dieses bestimmungsgemäßen Gebrauchs, also bei wiederholtem Ansaugen und Ablegen eines Gegenstands, unterliegt der Saugkörper 12 zumindest abschnittsweise einem gebrauchsbedingten Verschleiß, insbesondere im Bereich des Anlageabschnitts 14. Eine Hauptverschleißrichtung ist in den Figuren durch den mit Bezugszeichen 20 bezeichneten Pfeil angedeutet. Bei dem Verschleiß handelt es sich insbesondere um mechanischen Abrieb des Saugkörpermaterials, bspw. infolge von Reibung zwischen dem Saugkörper 12 und dem angesaugten Gegenstand.

Um einen Verschleißzustand des Saugkörpers 12 überwachen zu können, umfasst die Sauggreifereinrichtung 10 eine Verschleißdetektionseinrichtung 22. Die Verschleißdetektionseinrichtung 22 umfasst eine Magnetfeldeinrichtung 24 zum Bereitstellen eines Prüfmagnetfeldes 26, welches sich wie nachfolgend noch näher erläutert in Abhängigkeit eines Verschleißzustandes des Saugkörpers 12 verändert. Außerdem umfasst die Verschleißdetektionseinrichtung 22 eine Sensoreinrichtung 28 zur Detektion des Prüfmagnetfeldes 26. Beispielhaft und bevorzugt kann die Sensoreinrichtung 28 wenigstens einen Magnetfeldsensor 30 umfassen, insbesondere einen Hall-Sensor.

Bei der in Figur 1 dargestellten Ausgestaltung umfasst die Magnetfeldeinrichtung 24 ein Magnetmaterial 32, welches dazu ausgebildet ist, ein Magnetfeld 34 selbst bereitzustellen. In diesem Fall bildet das von dem Magnetmaterial 32 abgegebene Magnetfeld das Prüfmagnetfeld 26. Beispielhaft und bevorzugt handelt es sich bei dem Magnetmaterial 32 um ein permanent-magnetisches Material 40.

Die Verschleißdetektion basiert auf dem Grundprinzip, dass das Magnetmaterial 32 im Zuge des gebrauchsbedingten Verschleißes des Saugkörpers 12 selbst verschleißt, insbesondere einem mechanischen Abrieb unterliegt, und somit seine magnetischen Eigenschaften ändert. Eine Veränderung des von dem Magnetmaterial 32 bereitgestellten Magnetfeldes 34 wird dann von der Sensoreinrichtung 28 detektiert und daraus ein Verschleißzustand des Saugkörpers 12 ermittelt.

In dem dargestellten Beispiel ist das Magnetmaterial 32 in Form eines Prüfkörpers 38 bereitgestellt. Wie aus Figur 1 ersichtlich, ist der Prüfkörper 38 beispielhaft in den Saugkörper 12 integriert. Insbesondere ist der Prüfkörper 38 derart angeordnet, dass er mit einer Verschleißfläche 42 mit dem Anlageabschnitt 14 des Saugkörpers 12 bündig abschließt. Im Zuge eines gebrauchsbedingten Verschleißes des Saugkörpers 12 verschleißt der Prüfkörper 38 insofern stets mit.

Bei nicht dargestellten Ausgestaltungen ist es auch möglich, dass der Prüfkörper 38 in einer vorgegebenen Tiefenposition in der Verschleißrichtung 20 angeordnet ist, also von dem Anlageabschnitt 14 in Verschleißrichtung 20 betrachtet beabstandet angeordnet ist. Dann verschleißt der Prüfkörper 38 erst bei Erreichen eines gewissen Verschleißgrades des Saugkörpers 12, also erst dann, wenn der Saugkörper 12 bereits zu einem gewissen Grad abgenutzt ist. Es ist grundsätzlich auch denkbar, dass eine Mehrzahl von Prüfkörpern 38 vorgesehen ist.

Die Figur 2 zeigt eine weitere Ausgestaltung der Sauggreifereinrichtung 10, welche sich von der Ausgestaltung gemäß Figur 1 durch die Ausgestaltung der Verschleißdetektionseinrichtung 22 unterscheidet. Im Übrigen entspricht die Ausgestaltung gemäß Figur 2 aber der Ausgestaltung gemäß Figur 1.

Bei der in Figur 2 dargestellten Ausgestaltung wird das Prüfmagnetfeld nicht von dem Magnetmaterial 32 bzw. dem Prüfkörper 38 selbst bereitgestellt, sondern dadurch, dass ein Anregungsmagnetfeld durch das Magnetmaterial 32 verändert wird. In diesem Fall bildet also das von dem Magnetmaterial 32 veränderte Anregungsmagnetfeld das Prüfmagnetfeld. Zu diesem Zweck umfasst die Magnetfeldeinrichtung 24 zusätzlich zu dem Magnetmaterial 32 eine magnetfeldabgebende Einrichtung 36 zur Bereitstellung eines Anregungsmagnetfeldes. Bei dem Magnetmaterial 32 handelt es sich dann insbesondere um magnetisch polarisierbares Material, vorzugsweise um ferromagnetisches Material 46.

Bei der Ausgestaltung gemäß Figur 2 führt ein Verschleiß des Magnetmaterials 32 insofern zu einer Veränderung seiner Einwirkung auf das von der magnetfeldabgebenden Einrichtung 36 bereitgestellte Anregungsmagnetfeld.

In dem dargestellten Beispiel ist die magnetfeldabgebende Einrichtung 36 durch wenigstens einen Permanentmagneten 44 gebildet. Der Permanentmagnet 44 ist in dem dargestellten Beispiel in den Saugkörper 12 integriert. Es sind aber auch Ausgestaltungen denkbar, bei denen der Permanentmagnet 44 von dem Saugkörper 12 separat bereitgestellt ist.

Bei dem Magnetmaterial 32 kann es sich beispielhaft um ein Verbundmaterial aus einem ersten Material und magnetischen, insbesondere permanent-magnetischen oder ferromagnetischen, Füllkörpern handeln. Bei dem ersten Material kann es sich vorzugsweise um ein Elastomermaterial handeln, insbesondere um dasselbe Material, aus dem auch der Saugkörper 12 gefertigt ist.

Bei beiden Ausgestaltungen der Verschleißdetektionseinrichtung 22 ist es auch möglich, dass das Magnetmaterial 32 nicht durch einen Prüfkörper 38 bereitgestellt ist, sondern dass der Saugkörper 12 zumindest abschnittsweise aus dem Magnetmaterial 32 hergestellt ist.

Die Sauggreifereinrichtung 10 kann außerdem eine mit der Sensoreinrichtung 28 zusammenwirkende Auswerteeinrichtung (nicht dargestellt) umfassen. Beispielhaft ist die Auswerteeinrichtung dazu eingerichtet, in Abhängigkeit eines von der Sensoreinrichtung 28 detektierten Prüfmagnetfeldes 26 einen ein Verschleißsignal zu erzeugen, das den Verschleißzustand des Saugkörpers 12 repräsentiert. Hierzu kann die Auswerteeinrichtung beispielsweise eine Datenverarbeitungsanlage umfassen, welche dazu eingerichtet ist, ein von der Sensoreinrichtung 28 empfangenes Messsignal mit einem in einer Speichereinrichtung der Auswerteeinrichtung hinterlegten Referenzmesssignal zu vergleichen.

## Patentansprüche

1. Sauggreifereinrichtung (10), umfassend
- einen Saugkörper (12), welcher im Zuge seines bestimmungsgemäßen Gebrauchs zumindest abschnittsweise einem gebrauchsbedingten Verschleiß unterliegt
- eine Verschleißdetektionseinrichtung (22) zur Detektion eines Verschleißzustandes des Saugkörpers (12), umfassend
o eine Magnetfeldeinrichtung (24) zum Bereitstellen eines Prüfmagnetfeldes (26), wobei die Magnetfeldeinrichtung (24) derart ausgebildet ist, dass sich das bereitgestellte Prüfmagnetfeld (26) in Abhängigkeit eines fortschreitenden gebrauchsbedingten Verschleißes des Saugkörpers (12) verändert;
o eine Sensoreinrichtung (28), insbesondere umfassend wenigstens einen Magnetfeldsensor (30), zur Detektion des Prüfmagnetfeldes (26) .

2. Sauggreifereinrichtung (10) nach Anspruch 1, wobei die Magnetfeldeinrichtung (24) ein Magnetmaterial (32) umfasst, welches dazu ausgebildet ist, das Prüfmagnetfeld (26) selbst bereitzustellen oder das Prüfmagnetfeld (26) dadurch zu erzeugen, dass es ein von einer magnetfeldabgebende Einrichtung (36,44) bereitgestelltes Anregungsmagnetfeld verändert.

3. Sauggreifereinrichtung (10) nach Anspruch 2, wobei das Magnetmaterial (32) derart ausgebildet und angeordnet ist, dass es im Zuge eines gebrauchsbedingten Verschleißes des Saugkörpers (12), selbst verschleißt, insbesondere einem Materialabrieb unterliegt.

4. Sauggreifereinrichtung (10) nach Anspruch 3, wobei
das Magnetmaterial (32) derart ausgebildet und angeordnet ist, dass es bei einem gebrauchsbedingten Verschleiß des Saugkörpers (12) automatisch mit verschleißt,
oder
derart ausgebildet und angeordnet ist, dass es erst bei Erreichen eines vorgegebenen Verschleißgrades, insbesondere bei Erreichen einer vorgegebenen Abriebmenge, des Saugkörpers (12) verschleißt.

5. Sauggreifereinrichtung (10) nach einem der Ansprüche 2 bis 4, wobei es sich bei dem Magnetmaterial (32) um permanent-magnetisches Material (40) oder um magnetisch polarisierbares, insbesondere ferromagnetisches, Material (46) handelt.

6. Sauggreifereinrichtung (10) nach einem der Ansprüche 2 bis 5, wobei die Magnetfeldeinrichtung (24) eine magnetfeldabgebende Einrichtung (36) zur Bereitstellung eines Anregungsmagnetfeldes aufweist, insbesondere ein oder mehrere Permanentmagneten (44).

7. Sauggreifereinrichtung (10) nach einem der Ansprüche 2 bis 6, wobei das Magnetmaterial (32) ein Verbundmaterial aus einem ersten Material, insbesondere einem Elastomer oder einem Schaummaterial, und magnetischen, insbesondere permanent-magnetischen und/oder ferromagnetischen, Füllkörpern ist.

8. Sauggreifereinrichtung (10) nach einem der Ansprüche 2 bis 7, wobei der Saugkörper (12) zumindest abschnittsweise aus dem Magnetmaterial (32) hergestellt ist, insbesondere in einem Anlageabschnitt (14) zur Anlage an einen zu greifenden Gegenstand.

9. Sauggreifereinrichtung (10) nach einem der Ansprüche 2 bis 8, wobei das Magnetmaterial (32) in Form wenigstens eines Prüfkörpers (38) bereitgestellt ist.

10. Sauggreifereinrichtung (10) nach Anspruch 9, wobei der wenigstens eine Prüfkörper (38) in den Saugkörper (12) integriert ist, insbesondere in einer Saugkörperwandung des Saugkörpers (12) integriert ist, weiter insbesondere in einem den Saugkörper (12) bereitstellenden Saugkörpermaterial eingebettet ist.

11. Sauggreifereinrichtung (10) nach Anspruch 9, wobei der wenigstens eine Prüfkörper (38) von dem Saugkörper (12) separat bereitgestellt ist.

12. Sauggreifereinrichtung (10) nach einem der Ansprüche 9 bis 11, wobei der wenigstens eine Prüfkörper (38) in einer vorgegebenen Tiefenposition in einer Verschleißrichtung (20) angeordnet ist, insbesondere wobei die Tiefenposition einem Grenz-Verschleißgrad des Saugkörpers (12) entspricht, oder wobei eine Mehrzahl von Prüfkörpern (38) vorgesehen ist, welche in unterschiedlichen Tiefenpositionen in Verschleißrichtung (20) angeordnet sind.

13. Sauggreifereinrichtung (10) nach einem der Ansprüche 11 oder 12, wobei die Verschleißdetektionseinrichtung (22) als von dem Saugkörper (12) separat bereitgestelltes Detektionsmodul ausgebildet ist, insbesondere wobei das Detektionsmodul über eine Modulschnittstelle mit dem Saugkörper verbindbar ist.

14. Sauggreifereinrichtung (10) nach einem der vorherigen Ansprüche, wobei die Verschleißdetektionseinrichtung (22) außerdem eine mit der Sensoreinrichtung (28) zusammenwirkende Auswerteeinrichtung umfasst, welche dazu eingerichtet ist, in Abhängigkeit des von der Sensoreinrichtung (28) detektierten Prüfmagnetfeldes (26) ein Verschleißsignal zu erzeugen, das den Verschleißzustand des Saugkörpers (12) repräsentiert.

15. Sauggreifereinrichtung (10) nach einem der vorherigen Ansprüche, wobei die Auswerteeinrichtung dazu eingerichtet ist, zum Erzeugen des Verschleißsignals ein von der Sensoreinrichtung (28) empfangenes Messsignal mit einem in einer Speichereinrichtung der Auswerteeinrichtung hinterlegten Referenzmesssignal zu vergleichen,
insbesondere wobei das Verschleißsignal dann einen betriebsgeeigneten Verschleißzustand des Sauggreifers (12) repräsentiert, wenn das Messsignal einen vorgegebenen Schwellwert unterschreitet, und/oder wobei das Verschleißsignal einen dann betriebsungeeigneten Verschleißzustand des Sauggreifers (12) repräsentiert, wenn das Messsignal den Schwellwert überschreitet.

## Claims

1. Suction gripper device (10), comprising
- a suction body (12) which, when used as intended, is subjected to use-related wear, at least in portions,
- a wear detection device (22) for detecting a wear state of the suction body (12), comprising:
o a magnetic field device (24) for providing a test magnetic field (26), wherein the magnetic field device (24) is designed in such a way that the provided test magnetic field (26) changes depending on progressive use-related wear of the suction body (12);
o a sensor device (28), in particular comprising at least one magnetic field sensor (30), for detecting the test magnetic field (26).

2. Suction gripper device (10) according to claim 1,
wherein the magnetic field device (24) comprises a magnetic material (32) which is designed to provide the test magnetic field (26) itself or to generate the test magnetic field (26) by changing an excitation magnetic field provided by means of a magnetic field-emitting device (36, 44).

3. Suction gripper device (10) according to claim 2,
wherein the magnetic material (32) is designed and arranged in such a way that, in the course of use-related wear of the suction body (12), the material is itself worn, in particular is subject to material abrasion.

4. Suction gripper device (10) according to claim 3,
wherein the magnetic material (32) is designed and arranged in such a way that when the suction body (12) is worn as a result of use, the magnetic material is also automatically worn,
or
is designed and arranged in such a way that the magnetic material is only worn when the suction body (12) reaches a predetermined degree of wear, in particular reaches a predetermined amount of abrasion.

5. Suction gripper device (10) according to any of claims 2 to 4, wherein the magnetic material (32) is a permanent-magnetic material (40) or a magnetically polarizable, in particular ferromagnetic, material (46) .

6. Suction gripper device (10) according to any of claims 2 to 5, wherein the magnetic field device (24) has a magnetic field-emitting device (36) for providing an excitation magnetic field, in particular one or more permanent magnets (44).

7. Suction gripper device (10) according to any of claims 2 to 6, wherein the magnetic material (32) is a composite material comprising a first material, in particular an elastomer or a foam material, and magnetic, in particular permanent-magnetic and/or ferromagnetic, filling bodies.

8. Suction gripper device (10) according to any of claims 2 to 7, wherein the suction body (12) is produced, at least in portions, from the magnetic material (32), in particular in a contact portion (14) for contact with an object to be gripped.

9. Suction gripper device (10) according to any of claims 2 to 8, wherein the magnetic material (32) is provided in the form of at least one test body (38).

10. Suction gripper device (10) according to claim 9,
wherein the at least one test body (38) is integrated in the suction body (12), in particular is integrated in a suction body wall of the suction body (12), in particular is embedded in a suction body material providing the suction body (12).

11. Suction gripper device (10) according to claim 9,
wherein the at least one test body (38) is provided separately from the suction body (12).

12. Suction gripper device (10) according to any of claims 9 to 11, wherein the at least one test body (38) is arranged in a predetermined depth position in a wear direction (20), in particular wherein the depth position corresponds to a limiting degree of wear of the suction body (12), or wherein a plurality of test bodies (38) is provided, which are arranged in different depth positions in the wear direction (20).

13. Suction gripper device (10) according to claim 11 or claim 12, wherein the wear detection device (22) is designed as a detection module provided separately from the suction body (12), in particular wherein the detection module can be connected to the suction body via a module interface.

14. Suction gripper device (10) according to any of the preceding claims, wherein the wear detection device (22) also comprises an evaluation device interacting with the sensor device (28), which evaluation device is designed to generate a wear signal, which represents the wear state of the suction body (12), depending on the test magnetic field (26) detected by the sensor device (28).

15. Suction gripper device (10) according to any of the preceding claims, wherein the evaluation device is designed to compare a measurement signal received from the sensor device (28) with a reference measurement signal stored in a storage device of the evaluation device in order to generate the wear signal,
in particular wherein the wear signal represents a wear condition of the suction gripper (12) that is suitable for operation when the measurement signal falls below a predetermined threshold value, and/or
wherein the wear signal represents a wear condition of the suction pad (12) that is unsuitable for operation when the measurement signal exceeds the threshold value.

## Revendications

1. Dispositif à ventouse (10) comprenant
- un corps d'aspiration (12) qui est soumis à une usure due à l'utilisation, au moins par sections, au cours de son utilisation prévue,
- un dispositif de détection d'usure (22) destiné à détecter un état d'usure du corps d'aspiration (12), comprenant
o un dispositif de champ magnétique (24) destiné à fournir un champ magnétique de test (26), dans lequel le dispositif de champ magnétique (24) est conçu de telle sorte que le champ magnétique de test (26) fourni change en fonction d'une usure progressive du corps d'aspiration (12) qui est due à l'utilisation;
o un dispositif capteur (28) comprenant en particulier au moins un capteur de champ magnétique (30) pour détecter le champ magnétique de test (26).

2. Dispositif à ventouse (10) selon la revendication 1, dans lequel le dispositif de champ magnétique (24) comprend un matériau magnétique (32) qui est conçu pour fournir lui-même le champ magnétique de test (26) ou pour générer le champ magnétique de test (26) par le fait qu'il modifie un champ magnétique d'excitation fourni par un dispositif émetteur de champ magnétique (36, 44).

3. Dispositif à ventouse (10) selon la revendication 2, dans lequel le matériau magnétique (32) est conçu et agencé de telle sorte qu'il s'use lui-même au cours d'une usure du corps d'aspiration (12), qui est due à l'utilisation, en particulier est soumis à une abrasion de matériau.

4. Dispositif à ventouse (10) selon la revendication 3,
dans lequel le matériau magnétique (32) est conçu et agencé de telle sorte qu'il s'use automatiquement lorsque le corps d'aspiration (12) s'use du fait de l'utilisation,
ou
est conçu et agencé de telle sorte qu'il ne s'use que lorsque le corps d'aspiration (12) atteint un degré d'usure prédéterminé, en particulier lorsqu'une quantité d'abrasion prédéterminée est atteinte.

5. Dispositif à ventouse (10) selon l'une quelconque des revendications 2 à 4, dans lequel le matériau magnétique (32) est un matériau à aimantation permanente (40) ou un matériau magnétiquement polarisable, en particulier ferromagnétique (46).

6. Dispositif à ventouse (10) selon l'une quelconque des revendications 2 à 5, dans lequel le dispositif de champ magnétique (24) comprend un dispositif émetteur de champ magnétique (36) pour fournir un champ magnétique d'excitation, en particulier un ou plusieurs aimants permanents (44).

7. Dispositif à ventouse (10) selon l'une quelconque des revendications 2 à 6, dans lequel le matériau magnétique (32) est un matériau composite constitué d'un premier matériau, en particulier d'un élastomère ou d'un matériau mousse, et de charges magnétiques, en particulier à aimantation permanent et/ou ferromagnétiques.

8. Dispositif à ventouse (10) selon l'une quelconque des revendications 2 à 7, dans lequel le corps d'aspiration (12) est réalisé au moins par sections en matériau magnétique (32), en particulier dans une section d'appui (14) pour venir s'appliquer contre un objet à saisir.

9. Dispositif à ventouse (10) selon l'une quelconque des revendications 2 à 8, dans lequel le matériau magnétique (32) est fourni sous la forme d'au moins une éprouvette (38).

10. Dispositif à ventouse (10) selon la revendication 9, dans lequel ladite au moins une éprouvette (38) est intégrée au corps d'aspiration (12), en particulier est intégrée dans une paroi de corps d'aspiration du corps d'aspiration (12), en outre en particulier est encastrée dans un matériau de corps d'aspiration fournissant le corps d'aspiration (12).

11. Dispositif à ventouse (10) selon la revendication 9, dans lequel ladite au moins une éprouvette (38) est fournie séparément du corps d'aspiration (12).

12. Dispositif à ventouse (10) selon l'une quelconque des revendications 9 à 11, dans lequel ladite au moins une éprouvette (38) est disposée dans une position de profondeur prédéterminée dans une direction d'usure (20), en particulier dans lequel la position de profondeur correspond à un degré d'usure limite du corps d'aspiration (12), ou dans lequel une pluralité d'éprouvettes (38) est prévue qui sont disposées dans différentes positions de profondeur dans la direction d'usure (20).

13. Dispositif à ventouse (10) selon l'une quelconque des revendications 11 ou 12, dans lequel le dispositif de détection d'usure (22) est conçu en tant que module de détection fourni séparément du corps d'aspiration (12), en particulier dans lequel le module de détection peut être connecté au corps d'aspiration via une interface de module.

14. Dispositif à ventouse (10) selon l'une quelconque des revendications précédentes, dans lequel le dispositif de détection d'usure (22) comprend en outre un dispositif d'évaluation qui agit de concert avec le dispositif capteur (28) et qui est conçu pour générer, en fonction du champ magnétique de test (26) détecté par le dispositif capteur (28), un signal d'usure qui représente l'état d'usure du corps d'aspiration (12).

15. Dispositif à ventouse (10) selon l'une quelconque des revendications précédentes, dans lequel, pour générer le signal d'usure, le dispositif d'évaluation est conçu pour comparer un signal de mesure reçu du dispositif capteur (28) à un signal de mesure de référence stocké dans un dispositif de stockage du dispositif d'évaluation,
en particulier dans lequel le signal d'usure représente un état d'usure fonctionnellement approprié de la ventouse (12) lorsque le signal de mesure passe en dessous d'une valeur de seuil prédéterminée, et/ou
dans lequel le signal d'usure représente un état d'usure de la ventouse (12), qui est impropre au fonctionnement, lorsque le signal de mesure dépasse la valeur de seuil.
